# EUROPEAN PATENT APPLICATION

(11) **EP 2 634 883 A2**
(43) Date of publication of application: **04.09.2013**
(21) Application number: 13156656.4
(22) Date of filing: 25.02.2013
(51) Int. Cl.: H02H 3/20, G01R 19/165, H02H 3/027, H02H 3/247

(54) **Electronic device and protection circuit and protection method**

(30) Priority: 29.02.2012 CN 201210048992
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Ma, Xiao-Hui, 518109 Shenzhen City (CN); Li, Xin-Ping, 518109 Shenzhen City (CN)
(74) Representative: Gray, John James

(57) **Abstract**

A protection circuit (20) protects an electronic device (100) that is powered by a supply voltage of a power source (200). The electronic device (100) includes a processor (10) that is capable of performing a power-off procedure to cause the electronic device (100) to be powered off. The protection circuit (20) includes a storage unit (22), a detecting unit (24), and a comparator (26). The storage unit (22) stores a power-off threshold voltage. The detecting unit (24) detects the supply voltage of the power source (200) to generate a detecting voltage. The comparator (26) determines whether the detecting voltage is equal to the power-off threshold voltage, begins to count for a first predetermined period of time when the detecting voltage is equal to the power-off threshold voltage, and acquires the detecting voltage from the detecting unit (24) during the first predetermined period of time. The comparator (26) further determines whether each acquired detecting voltage is smaller than the power-off threshold voltage, and generates a first control signal when one of the acquired detecting voltages is larger than or is equal to the power-off threshold voltage. The first control signal controls the processor (10) to stop performing the power-off procedure.

## Description

### Description of Related Art

An electronic device can be powered by a supply voltage of a power source, for example, a power adaptor or a battery. Generally, there may be a voltage drop in the supply voltage due to a brownout or power failure of the power source. However, due to the voltage drop, the supply voltage may be lower than a power-off threshold voltage, causing the electronic device to mistakenly perform a power-off. This is inconvenient.

Therefore, there is room for improvement in the art.

### Summary

According to an exemplary embodiment of the invention, a protection circuit protects an electronic device that is powered by a supply voltage of a power source. The electronic device includes a processor that is capable of performing a power-off procedure to cause the electronic device to be powered off. The protection circuit includes a storage unit, a detecting unit, and a comparator. The storage unit stores a power-off threshold voltage. The detecting unit detects the supply voltage of the power source to generate a detecting voltage. The comparator determines whether the detecting voltage is equal to the power-off threshold voltage, begins to count for a first predetermined period of time when the detecting voltage is equal to the power-off threshold voltage, and acquires the detecting voltage from the detecting unit during the first predetermined period of time. The comparator further determines whether each acquired detecting voltage is smaller than the power-off threshold voltage, and generates a first control signal when one of the acquired detecting voltages is larger than or is equal to the power-off threshold voltage. The first control signal controls the processor to stop performing the power-off procedure. Therefore, the electronic device can be prevented from being mistakenly powered off.

### BRIEF DESCRIPTION OF THE DRAWINGS

The components of the drawings are not necessarily drawn to scale, the emphasis instead being placed upon clearly illustrating the principles of the embodiments of an electronic device. Moreover, in the drawings, like reference numerals designate corresponding parts throughout three views.

FIG. 1 is a block diagram of an electronic device in accordance with one embodiment.

FIG. 2 is a waveform diagram generated by the electronic device of FIG. 1.

FIG. 3 is flowchart showing a protection method executed by the electronic device of FIG. 1 in accordance with one embodiment.

### DETAILED DESCRIPTION

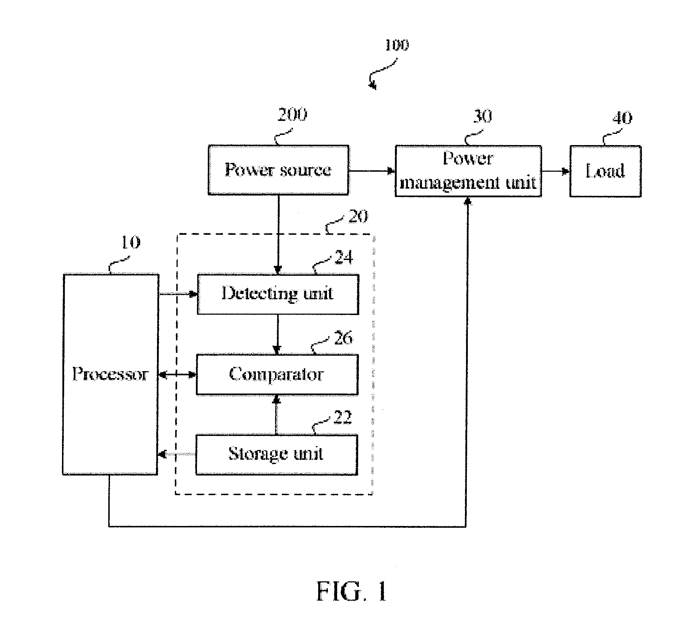

Referring to FIG. 1, an electronic device 100 is powered by a supply voltage of a power source 200. The electronic device 100 includes a processor 10, a protection circuit 20, a power management unit 30, and a load 40. The processor 10 is capable of performing a power off procedure to cause the electronic device to be powered off in response to a power off command. In this embodiment, when a user presses a button (not shown) disposed on the electronic device, the power off command is generated.

The protection circuit 20 causes the electronic device 100 to be protected. The protection circuit 20 includes a storage unit 22, a detecting unit 24, and a comparator 26. The storage unit 22 stores a power-off threshold voltage. The detecting unit 24 detects the supply voltage of the power source 200 to generate a detecting voltage. The comparator 26 determines whether the detecting voltage is equal to the power-off threshold voltage, begins to count for a first predetermined period of time when the detecting voltage is equal to the power-off threshold voltage, and acquires the detecting voltage from the detecting unit 24 during the first predetermined period of time.

The comparator 26 further determines whether each acquired detecting voltage is smaller than the power-off threshold voltage, generates a first control signal when one of the acquired detecting voltages is larger than or is equal to the power-off threshold voltage, and generates a second control signal when all acquired detecting voltages are smaller than the power-off threshold voltage. The first control signal controls the processor 10 to stop performing the power-off procedure, and the second control signal controls the processor 10 to perform the power-off procedure.

The storage unit 22 further stores a second predetermined period of time during which a power failure of the power source 200 occurs, a predetermined voltage drop in the supply voltage due to the power failure of the power source 200, and an over-discharge protection voltage. In this embodiment, the first predetermined period of time is larger than the second predetermined period of time, preferably, the first predetermined period of time is equal to a sum of the second predetermined period of time and one second. Therefore, when the power failure of the power source 200 occurs, during the second predetermined period of time, there is a voltage drop in the supply voltage of the power source 200, thus the supply voltage of the power source 200 is decreased. In this embodiment, during the first predetermined period of time, the comparator 26 acquires the detecting voltage from the detecting unit 24 at a predetermined interval, the predetermined interval is equal to the second predetermined period of time divided by 20. During the first predetermined period of time, the electronic device 100 is powered off when each detected voltage is smaller than the power-off threshold voltage. Further because there are a plurality of predetermined periods of time during which the power failure of the power source 200 occurs, and the second predetermined period of time is equal to one of the plurality of predetermined periods of time which has a maximum value. Therefore, during the predetermined period of time in which the power failure of the power source 200 occurs, the electronic device 100 can be prevented from being mistakenly powered off.

The comparator 26 further determines whether the detecting voltage is smaller than the over-discharge protection voltage and generates a third control signal when the detecting voltage is larger than or is equal to the over-discharge protection voltage, the third control signal enables the processor to control the power management unit to allow the supply voltage of the power source 200 to be transmitted to the load 40, therefore the supply voltage powers the load 40. The comparator 26 further generates a fourth control signal when the detecting voltage is smaller than the over-discharge protection voltage; the fourth control signal enables the processor 10 to control the power management unit 30 to prevent the supply voltage of the power source 200 from reaching the load 40, that is, the power management unit 30 is disabled, therefore the supply voltage stops powering the load 40 and the over-discharge protection for the power source 200 is realized.

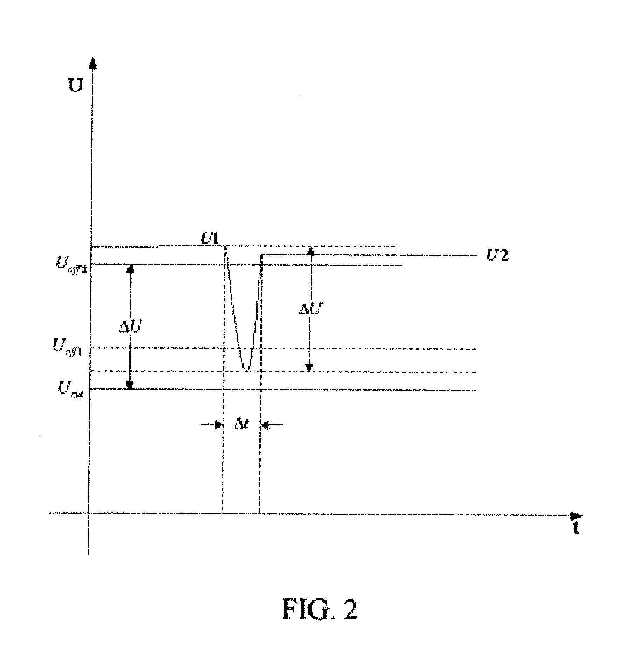

Referring to FIG. 2, in this embodiment, the power-off threshold voltage Voff2 is equal to a sum of the over-discharge protection voltage Vcut and the predetermined voltage drop ΔU. The second predetermined period of time during which the power failure of the power source 200 occurs is labeled as Δt. In this embodiment, the detecting voltage is equal to the supply voltage of the power source 200. In other embodiments, the detecting voltage may be larger than or smaller than the supply voltage. There are a plurality of voltage drops in the supply voltage of the power source 200 respectively due to a plurality of power failures of the power source 200, and the predetermined voltage drop ΔU is equal to one of the plurality of voltage drops which has a maximum value. Because the predetermined voltage drop ΔU is equal to one of the plurality of voltage drops which has a maximum value, when the power failure of the power source 200 is occurred, the supply voltage of the power source 200 is larger than or is equal to the over-discharge protection voltage Vcut, and the power management unit 30 can be prevented from being mistakenly disabled.

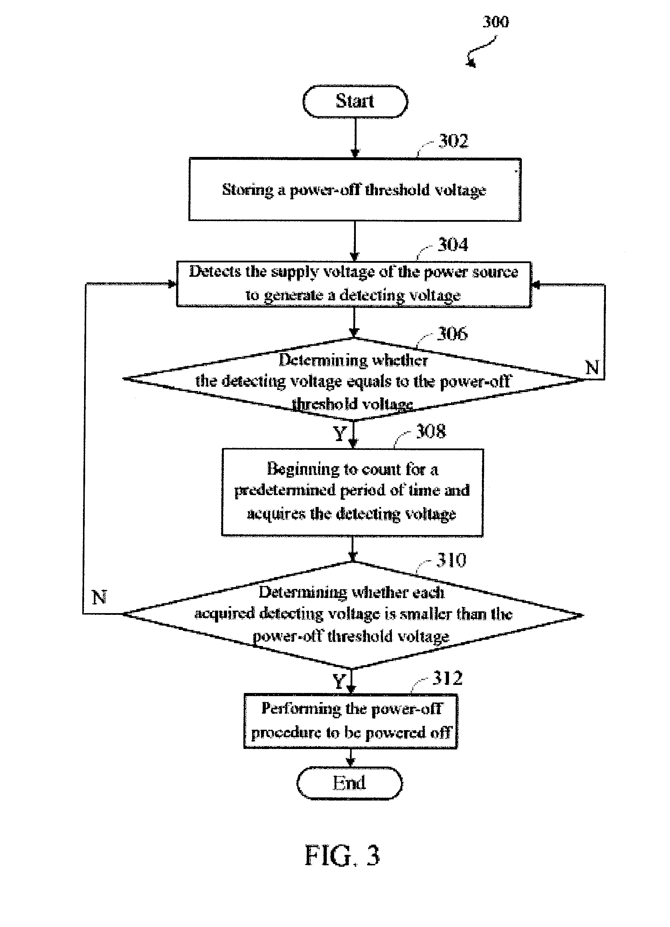

Referring to FIG. 3, a protection method 300 that is executed by the electronic device 100 is illustrated, the protection method 300 includes following steps:

Step 302: the storage unit 22 stores the power-off threshold voltage.

Step 304: the detecting unit 24 detects the supply voltage of the power source 200 to generate the detecting voltage.
Step 306: the comparator 26 determines whether the detecting voltage is equal to the power-off threshold voltage. If the detecting voltage is equal to the power-off threshold voltage, the procedure goes to step 308; if the detecting voltage is not equal to the power-off threshold voltage, the procedure goes to step 304;

Step 308: the comparator 26 begins to count for the first predetermined period of time and acquires the detecting voltage from the detecting unit 24 during the first predetermined period of time.

Step 310: the comparator 26 further determines whether each acquired detecting voltage is smaller than the power-off threshold voltage. If one of the acquired detecting voltages is larger than or is equal to the power-off threshold voltage, the procedure goes to step 304. If all acquired detecting voltages are smaller than the power-off threshold voltage, the procedure goes to step 312.

Step 312: the processor 10 performs the power-off procedure to be powered off.

Further alternative embodiments will become apparent to those skilled in the art without departing from the spirit and scope of what is claimed. Accordingly, the present invention should be deemed not to be limited to the above detailed description, but rather only by the claims that follow and equivalents thereof.

## Claims

1. A protection circuit causing an electronic device that is powered by a supply voltage of a power source to be protected, the electronic device comprising a processor that is capable of performing a power-off procedure to cause the electronic device to be powered off, the protection circuit comprising:
a storage unit storing a power-off threshold voltage;
a detecting unit detecting the supply voltage of the power source to generate a detecting voltage; and
a comparator determining whether the detecting voltage is equal to the power-off threshold voltage, beginning to count for a first predetermined period of time when the detecting voltage is equal to the power-off threshold voltage,
and acquiring the detecting voltage from the detecting unit during the first predetermined period of time;
wherein the comparator further determines whether each acquired detecting voltage is smaller than the power-off threshold voltage, and generates a first control signal when one of the acquired detecting voltages is larger than or is equal to the power-off threshold voltage; the first control signal controls the processor to stop performing the power-off procedure.

2. The protection circuit of claim 1, wherein the comparator further generates a second control signal when all acquired detecting voltages are smaller than the power-off threshold voltage, the second control signal controls the processor to perform the power-off procedure.

3. The protection circuit of claim 1 or 2, wherein the electronic device further comprises a power management unit and a load, the power management unit is capable of allowing the supply voltage of the power source to be transmitted to the load, the storage unit further stores a predetermined voltage drop in the supply voltage due to a power failure of the power source and an over-discharge protection voltage; the comparator further determines whether the detecting voltage is smaller than the over-discharge protection voltage and generates a third control signal when the detecting voltage is smaller than the over-discharge protection voltage; the third control signal enables the processor to control the power management unit to prevent the supply voltage of the power source from reaching the load, the power-off threshold voltage is equal to a sum of the over-discharge protection voltage and the predetermined voltage drop.

4. The protection circuit of claim 3, wherein the comparator further generates a fourth control signal when the detecting voltage is larger than or is equal to the over-discharge protection voltage, the fourth control signal enables the processor to control the power management unit to allow the supply voltage of the power source to be transmitted to the load.

5. The protection circuit of claim 2, 3 or 4, wherein the storage unit stores a second predetermined period of time during which the power failure of the power source occurs, and the first predetermined period of time is larger than the second predetermined period of time.

6. The protection circuit of claim 5, wherein the first predetermined period of time is equal to a sum of the second predetermined period of time and one second.

7. The protection circuit of claim 5, wherein during the first predetermined period of time, the comparator acquires the detecting voltage from the detecting unit at a predetermined interval, the predetermined interval is equal to the second predetermined period of time divided by 20.

8. The protection circuit of claim 3 or 4, wherein there are a plurality of voltage drops in the supply voltage of the power source respectively due to a plurality of power failures of the power source, and the predetermined voltage drop is equal to one of the plurality of voltage drops which has a maximum value.

9. The protection circuit of claim 5, wherein there are a plurality of predetermined periods of time during which the power failure of the power source occurs, and the second predetermined period of time is equal to one of the plurality of predetermined periods of time which has a maximum value.

10. An electronic device powered by a supply voltage of a power source, the electronic device comprising:
a processor capable of performing a power-off procedure to cause the electronic device to be powered off; and
a protection circuit comprising:
a storage unit storing a power-off threshold voltage;
a detecting unit detecting the supply voltage of the power source to generate a detecting voltage; and
a comparator determining whether the detecting voltage is equal to the power-off threshold voltage, beginning to count for a first predetermined period of time when the detecting voltage is equal to the power-off threshold voltage,
and acquiring the detecting voltage from the detecting unit during the first predetermined period of time;
wherein the comparator further determines whether each acquired detecting voltage is smaller than the power-off threshold voltage, and generates a first control signal when one of the acquired detecting voltages is larger than or is equal to the power-off threshold voltage; the processor stops performing the power-off procedure in response to the first control signal.

11. The electronic device of claim 10, wherein the comparator further generates a second control signal when all acquired detecting voltages are smaller than the power-off threshold voltage, the processor performs the power-off procedure in response to the second control signal.

12. A protection method executed by an electronic device that is powered by a supply voltage of a power source, the electronic device comprising a processor that is capable of performing a power-off procedure to cause the electronic device to be powered off, the protection method comprising steps of:
storing a power-off threshold voltage;
detecting the supply voltage of the power source to generate a detecting voltage;
determining whether the detecting voltage is equal to the power-off threshold voltage;
beginning to count for a first predetermined period of time when the detecting voltage is equal to the power-off threshold voltage and acquiring the detecting voltage during the first predetermined period of time;
determining whether each acquired detecting voltage is smaller than the power-off threshold voltage; and
generating a first control signal when one of the acquired detecting voltages is larger than or is equal to the power-off threshold voltage; wherein the first control signal controls the processor to stop performing the power-off procedure.

13. The protection method of claim 12, further comprising the step of:
generating a second control signal when each acquired detecting voltage is smaller than the power-off threshold voltage, the second control signal controls the processor to perform the power-off procedure.

14. The protection method of claim 12 or 13, wherein the electronic device further comprises a power management unit and a load, the power management unit is capable of allowing the supply voltage of the power source to be transmitted to the load, the protection method further comprises the steps of:
storing a predetermined voltage drop in the supply voltage due to a power failure of the power source and an over-discharge protection voltage;
determining whether the detecting voltage is smaller than the over-discharge protection voltage; and
generating a third control signal when the detecting voltage is smaller than the over-discharge protection voltage;
wherein the third control signal enables the processor to control the power management unit to prevent the supply voltage of the power source from reaching the load, the power-off threshold voltage is equal to a sum of the over-discharge protection voltage and the predetermined voltage drop.

15. The protection method of claim 14, wherein there are a plurality of voltage drops in the supply voltage of the power source respectively due to a plurality of power failures of the power source, and the predetermined voltage drop is equal to one of the plurality of voltage drops which has a maximum value.
